# EUROPEAN PATENT APPLICATION

(11) **EP 4 761 118 A1**
(43) Date of publication of application: **17.06.2026**
(21) Application number: 24315575.1
(22) Date of filing: 13.12.2024
(51) Int. Cl.: H03M 1/36

(54) **AN APPARATUS AND METHOD FOR AMPLITUDE AND DURATION COMPARISON OF AN ANALOG SIGNAL**

(71) Applicant: NXP USA, Inc., Austin, TX 78735 (US)
(72) Inventor: Ryabchenkov, Sergey, 5656 Eindhoven (NL); Tiphaigne, Bruno, 31023 Toulouse (FR); Meunier, Philippe, 31023 Toulouse (FR); Kandah, Ibrahim, 5656 Eindhoven (NL); Baylac, Didier, 31023 Toulouse (FR)
(74) Representative: Schmütz, Christian Klaus Johannes

(57) **Abstract**

This disclosure generally relates to an apparatus and a method for amplitude and duration comparison of an analog signal, in particular for analog signals with noise.

## Description

### TECHNICAL FIELD

This disclosure generally relates to an apparatus and a method for amplitude and duration comparison of an analog signal, in particular for analog signals with noise.

### BACKGROUND

Analog signals may be characterized in terms of observed signal amplitudes over time. In some applications, analog signals may have noise as unwanted signal components. In some applications, a monitoring of analog signals, in particular of analog signals with noise, may be required.

### SUMMARY

According to a first aspect of the present disclosure, there is provided an apparatus comprising: an input element comprising an analog signal node configured to receive at least one analog signal.

The apparatus may further comprise: a plurality of amplitude sensing elements, each amplitude sensing element configured to: receive the at least one analog signal from the analog signal node, detect if the at least one analog signal at the analog signal node exceeds a respective amplitude threshold level associated with the amplitude sensing element, and provide an amplitude signal at an amplitude output based on the detection.

The apparatus may further comprise: a plurality of groups of duration detection elements, each group of duration detection elements associated with one amplitude sensing element from the plurality of amplitude sensing elements, and each duration detection element comprising a time filter element, wherein each duration detection element is configured to: receive the amplitude signal from the amplitude output of the associated amplitude sensing element, detect if a duration of the received amplitude signal exceeds a respective time threshold associated with the time filter element of the duration detection element, and provide a duration signal based on the detection.

The apparatus may further comprise: a counter element configured to store a count based on the respective duration signals of each duration detection element.

In one or more embodiments, the input element further comprises: a plurality of analog input nodes, and a selector, configured to select an input node from the plurality of input nodes and to connect the selected input node to the analog signal node.

In one or more embodiments, the received at least one analog signal is coupled to the analog signal node via a first capacitor.

In one or more embodiments, the input element further comprises a trimmable voltage divider, comprising: a first trimmable resistor, a second trimmable resistor, and a switch, wherein the first trimmable resistor and the second trimmable resistor are coupled to the analog signal node and wherein the first trimmable resistor is coupled to a voltage supply and the second trimmable resistor is coupled through the switch to a ground potential.

In one or more embodiments, at least one amplitude sensing element of the plurality of amplitude sensing elements further comprises: a first amplifier with a first amplifier input and a first amplifier output, the first amplifier input coupled to the input of the amplitude sensing element, wherein the first amplifier is an inverter, and wherein the first amplifier is configured with the associated amplitude threshold level of the amplitude sensing element; a second amplifier, wherein the second amplifier is an inverter or a buffer, the second amplifier comprising a second amplifier input and a second amplifier output, the second amplifier input coupled to the first amplifier output and the second amplifier output coupled to the amplitude output of the amplitude sensing element.

In one or more embodiments, each of the second amplifiers has a common second threshold level.

In one or more embodiments, the plurality of amplitude sensing elements comprises a first group and a second group, wherein in the first group all of the amplitude threshold levels are positive amplitude threshold levels above a reference level, and wherein in the second group all of the amplitude threshold levels are negative amplitude threshold values below the reference level.

In one or more embodiments, at least one time filter element of the duration detection element comprises: a filter resistor with a first filter resistor node and a second filter resistor node, and a filter capacitor with a first filter capacitor node and a second filter capacitor node.

In one or more embodiments, in at least one time filter element: the first filter resistor node is coupled to the amplitude input and the second filter resistor node is coupled to the counter element; and wherein the first filter capacitor node is coupled to the filter resistor node and the second filter capacitor node is coupled to a ground potential.

In one or more embodiments, at least one duration detection element comprises: a third amplifier coupled between the amplitude input and at least one of the duration detection elements.

In one or more embodiments, at least one time filter element further comprises: a fourth amplifier configured as a buffer and coupled between the amplitude input and the counter element.

In one or more embodiments, at least one time filter element further comprises: a fourth amplifier configured as a buffer and coupled between the amplitude input and the counter element. The fourth amplifier is coupled between the second filter resistor node and the counter element.

In one or more embodiments, wherein the counter element comprises: a plurality of registers for storing a histogram of noise and a reset input for resetting the plurality of registers.

In one or more embodiments, the apparatus further comprises: a control unit, the control unit configured to at least one of the following: trigger at least one measurement of the apparatus to store at least one noise histogram in the counter element for the at least one measurement and further configured to determine at least one of safety status and a lifetime status, based on the at least one noise histogram, trim the input element to a reference voltage level.

According to a second aspect of the present disclosure, there is provided A method controlled by a control unit, the method comprising: receiving at least one analog signal at an analog input; comparing the analog signal with a plurality of amplitude threshold levels by a plurality of amplitude sensing elements to generate a plurality of amplitude output signals; time-filtering each of the plurality of amplitude output signals using a time filter element to obtain a plurality of time signals for each amplitude output signal; storing the plurality of time signals.

In one or more embodiments, the method further comprises: determining, for a device, based on the plurality of time signals at least one of the following: a noise histogram, a safety status, a lifetime status.

In one or more embodiments, the method further comprises: quantifying at least one of the following noise parameters for the at least one analog signal based on the plurality of time signals: amplitude, polarity, duration.

In one or more embodiments, the method further comprises: repeating the steps of receiving, comparing, time-filtering, and storing at a plurality of times to obtain a temporal evolution of a noise histogram.

In one or more embodiments, the method further comprises: making a pass/fail decision based on the at least one noise histogram.

In one or more embodiments, the method the method is a built-in self-test, BIST.

The above discussion is not intended to represent every example embodiment or every implementation within the scope of the current or future Claim sets. The Figures and Detailed Description that follow also exemplify various example embodiments. Various example embodiments may be more completely understood in consideration of the following Detailed Description in connection with the accompanying Drawings.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
- Fig. 1:: an apparatus according to an example embodiment;
- Fig. 2:: an input element according to an example embodiment;
- Fig. 3:: a plurality of groups of detection elements according to an example embodiment;
- Fig. 4:: a group of duration detection elements according to an example embodiment;
- Fig. 5a:: a histogram according to an example embodiment;
- Fig. 5b:: a histogram according to an example embodiment; and
- Fig. 6:: a method according to an example embodiment.

### DETAILED DESCRIPTION

Performance of integrated circuits, for example in environments in which electrical noise occurs is a challenging task, for example in automotive systems. Diagnostic capabilities of analog signals, for example of analog signals which are susceptible to noise, may be helpful for various applications, for example for understanding the operating conditions of devices and/or electrical circuitry, for example during device and system development.

There may be a need for improving or enabling built in self-test, BIST, which analyzes analog signals which may comprise noise received from single or multiple nodes. The ability to ' analyze these analog signals may improve system robustness.

It may be advantageous to allow advanced monitoring of analog signals which for example provides information regarding factors such as polarity, amplitude, and/or duration of noise superposed on analog signals, for example noise in analog signals. Further, it may be advantageous to be able to analyze one or more analog signals at specific different times, for example during time intervals in which noisy events may occur, for example during startup, during operation, and/or during shutdown. This may be helpful for diagnosis of customer quality incidents, QCI. Additionally or alternatively, monitoring of analog signals may enable permanent noise monitoring, for example of one or more defined nodes during system operation. This may facilitate detection of anomalies and may enable improved safety decisions. These requirements are at least in part addressed by this disclosure.

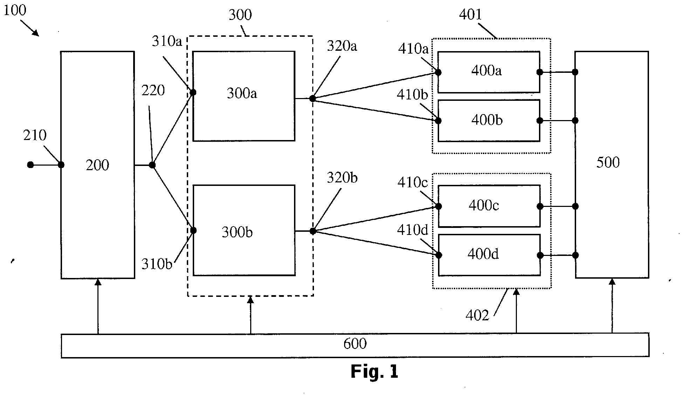

Fig. 1 shows an apparatus according to an example embodiment. Namely, Fig. 1 shows an apparatus 100. The apparatus 100 may comprise: an input element 200 comprising an analog signal node 220 configured to receive at least one analog signal.

The analog signal may comprise noise which shall be monitored as described herein.

As shown in Fig. 1, the apparatus 100 may further comprise: a plurality of amplitude sensing elements 300. Each amplitude sensing element 300a-300b may be configured to: receive the at least one analog signal from the analog signal node 220, detect if the at least one analog signal at the analog signal node 220 exceeds a respective amplitude threshold level associated with the amplitude sensing element, and provide an amplitude signal at an amplitude output 320a-320b; 320p1-320pn based on the detection.

Having individual amplitude sensing elements 300a-300b with respective amplitude threshold levels may allow individual detection of different noise amplitude levels, for example with positive and negative amplitude levels as further described herein.

Amplitude threshold levels may be a signed amplitude value, for example a signed voltage value of a threshold voltage.

By varying the number of amplitude sensing elements, the complexity of the apparatus 100 may be designed based on the required level of detail required for monitoring, for example noise monitoring. In some embodiments, the respective threshold levels are uniformly distributed for a range of possible noise amplitudes. The range of possible noise amplitudes may be known upfront. In other embodiments, the respective threshold levels may be non-uniformly distributed, for example with a linear subrange and with a logarithmic range to allow a large dynamic range of the apparatus 100 with respect to noise amplitude levels, for example for a priory unknown amplitude ranges.

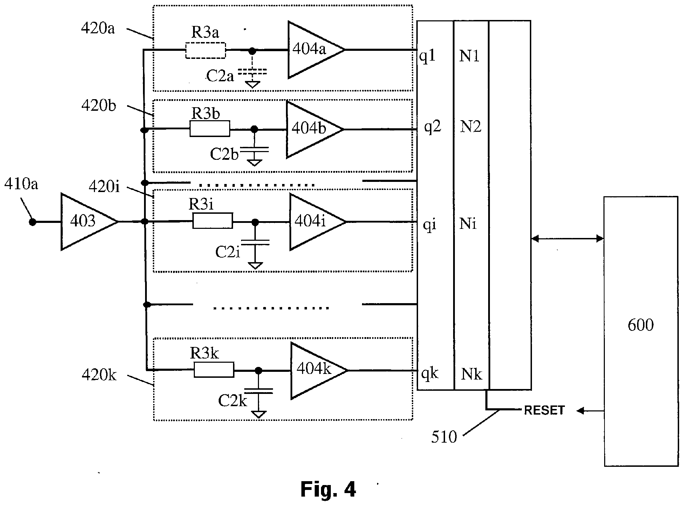

The apparatus 100 further comprises: a plurality of groups of duration detection elements 401, 402. Each group of duration detection elements 401, 402 may be associated with one amplitude sensing element from the plurality of amplitude sensing elements 300. Each duration detection element 400a-400d may comprise a time filter element, for example time filter element 420a-420k as shown in Fig. 4, but other time filter elements with different circuitry may be used.

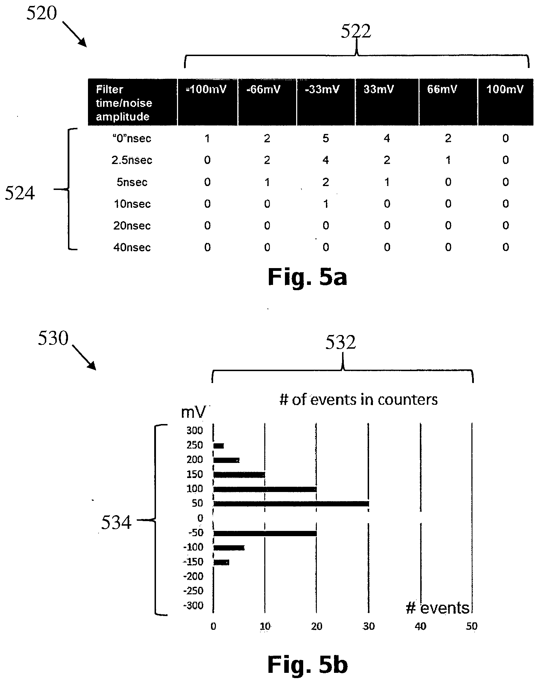

The use of a plurality of groups of duration detection elements may allow that a time and/or duration resolved measurement of the analog signal can be achieved, for example for each different amplitude threshold level. This may allow the creation of histograms of the analog signal, for example as will be explained with reference to Fig. 5a and Fig. 5b.

Each duration detection element, for example as shown in Fig. 1, may be configured to: receive the amplitude signal from the amplitude output 320a-320b of the associated amplitude sensing element, detect if a duration of the received amplitude signal exceeds a respective time threshold associated with the time filter element of the duration detection element, and/or provide a duration signal based on the detection.

This further enables creation of a histogram providing information about the analog signal. As the amplitude signal is received from the associated amplitude sensing element, the circuitry of the duration detection element may be simplified compared to other circuitry which is designed to receive analog signals with different amplitude levels.

The apparatus 100 may further comprise a counter element 500 configured to store a count based on the respective duration signals of each duration detection element.

This may allow collecting the information from the respective duration signals. Since the duration signals in turn are dependent on the amplitude signals, this allows storing of data to provide a histogram of the analog signal data.

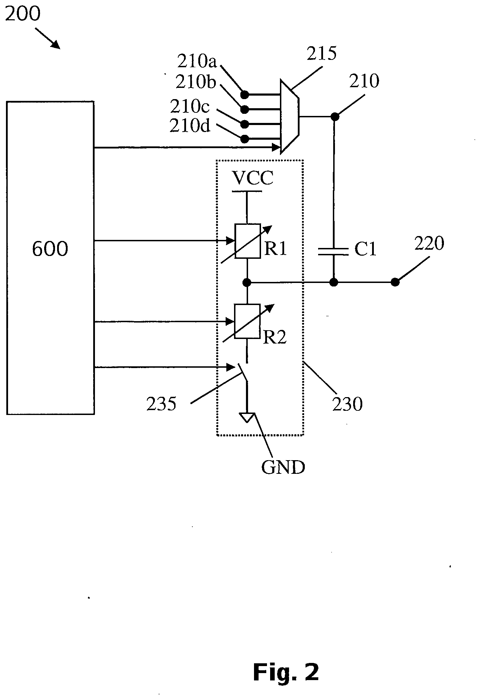

Fig. 2 shows an input element according to an example embodiment. The input element 200 may be the input element 200 shown in Fig. 1, but it may also be different. In the embodiment of Fig. 2, the input element 200 comprises a plurality of analog input nodes 210a, 210b, 210c, 210d. As shown in Fig. 2, the input element 200 may comprise a selector 215. The selector 215 may be configured to select an input node from the plurality of input nodes 210a, 210b, 210c, 210d and/or may be configured to connect the selected input node to the analog signal node 220.

Input elements which comprise a selector 215 may allow monitoring of different analog signals at different nodes. This may reduce complexity of the apparatus required for monitoring various analog signals.

As shown in the example of Fig. 2, the received at least one analog signal may be coupled to the analog signal node 220 via a first capacitor C1. This may allow filtering, for example high pass filtering of the analog signal.

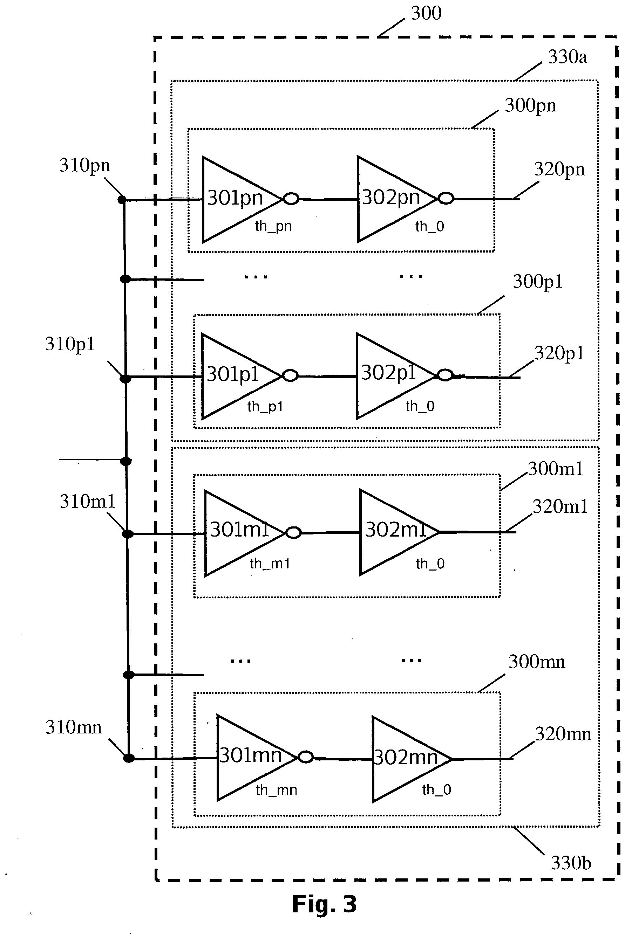

As shown in the example of Fig. 3, the input element 200 may further comprise a trimmable voltage divider 230. The trimmable voltage divider 230 may comprise: a first trimmable resistor R1, a second trimmable resistor R2, and a switch 235. The first trimmable resistor R1 and the second trimmable resistor R2 may be coupled to the analog signal node 220. The first trimmable resistor R1 may be coupled to a voltage supply VCC and the second trimmable resistor may be coupled through the switch 235 to a ground potential GND.

The input element 100 may be trimmed to the reference voltage level by trimming the trimmable voltage divider 230, for example by trimming at least one of the first trimmable resistor R1 and the second trimmable resistor R2 shown in Fig. 3, but other ways of trimming of different trimmable voltage dividers are possible. The reference voltage level may be the reference level previously described or it may be a different reference level.

The switch may allow conducting measurements at defined times as described elsewhere. The trimming may allow adjusting a reference voltage value to a reference level.

Fig. 3 shows a plurality of groups of detection elements according to an example embodiment. The detection elements shown in Fig. 3 may correspond to the detection elements shown in other figures, for example in Fig. 1. However, the detection elements may be different. In the embodiment of Fig. 3, at least one amplitude sensing element 300p1-300pn, 300m1-300mn of the plurality of amplitude sensing elements 300p1-300pn, 300m1-300mn further comprise: a first amplifier 301p1-301pn, 301m1-301mn with a first amplifier input and a first amplifier output. The first amplifier input may be coupled to the input, for example input 310a, 310b shown in Fig. 1, for example input 310p1-310pn; 310m1-310mn in Fig. 3, of the amplitude sensing element. The first amplifier may be an inverter.

For example, amplitude sensing element 300p1 of the plurality of amplitude sensing elements 300 further comprise: a first amplifier 301p1 with a first amplifier input 310p1 and a first amplifier output 320p1. As indicated in Fig. 3, the first amplifier input 310p1 may be coupled to the input of the amplitude sensing element. All inputs of the first amplifiers 310p1-310pn; 310m1-310mn may be connected with each other.

As shown in Fig. 3, the first amplifier 301p1-301pn, 301m1-301mn may be configured with the associated amplitude threshold level th_p1, th_pn; th_m1, th_mn of the amplitude sensing element.

The first amplifier may thus only activate if a signal at the first amplifier input exceeds the amplitude threshold level.

As shown in Fig. 3, at least one amplitude sensing element 300p1-300pn, 300m1-300mn of the plurality of amplitude sensing elements 300p1-300pn, 300m1-300mn may further comprise: a second amplifier 302p1-302pn, 302m1-302mn. The second amplifier may be an inverter or a buffer. The second amplifier may comprise a second amplifier input and a second amplifier output, the second amplifier input coupled to the first amplifier output and the second amplifier output coupled to the amplitude output of the amplitude sensing element.

In an amplifier, the difference between an input and an internal threshold may be amplified, for example with a changed polarity in an inverting amplifier or with identical polarity in a non-inverting amplifier. The first amplifier and other amplifiers described herein may be inverting amplifiers, implemented as simple inverters, for example implemented using two transistors. In other examples, amplifiers described herein may be non-inverting amplifiers, implemented as simple buffers, for example implemented as two serial inverters, for example implemented using two transistors in each of the two serial inverters.

Each of the second amplifiers may have a common second threshold level th_0. In other embodiments, individual second amplifiers may have different second threshold levels. Using a common second threshold level may simplify design and lead to a uniform temporal response of the second amplifier. Having different second threshold levels may increase design flexibility.

The plurality of amplitude sensing elements, for example amplitude sensing elements 300a, and 300b shown in Fig. 1 and amplitude sensing elements 300p1 to 300pn as well as 300m1 to 300mn shown in Fig. 3 may comprise a first group 330a and a second group 330b.

In the first group 330a, all of the amplitude threshold levels may be positive amplitude threshold levels th_p1, th_pi, th_pT-1, th_pT above a reference level, and in the second group 330b all of the amplitude threshold levels are negative amplitude threshold values th_m1, th_m2, th_mi, th_mT below the reference level.

As shown in Fig. 3, some or all second amplifiers 302p1-302pn in the first group 330a may be inverters and some or all second amplifiers 302m1-302mn in the second group 330b may be buffers.

This may allow simple monitoring of both positive and negative amplitudes of the analog signal. In some embodiments, only the first group 330a or only the second group 330b may be present. This may reduce complexity, for example if only noise of a single polarity is expected or relevant for an application. The number of amplitude sensing elements in the first group and the second group may be identical, in other words mn=pn with the indices shown in Fig. 3 which shows p1...pn amplitude sensing elements in the first group 330a and m1...mn amplitude sensing elements in the second group 330b. In other embodiments, the number of amplitude sensing elements may be different, for example mn=2 · pn if a higher resolution of the negative signal amplitude is required or vice versa etc.

The reference level may be a reference voltage level and/or may be the reference level determined by the trimmable voltage divider described herein.

Fig. 4 shows a group of duration detection elements according to an example embodiment, for example duration detection elements 400a-400d shown in Fig. 1.

As shown in Fig. 4, at least one time filter element 420a-420k of the duration detection t element 400a-400d may comprise: a filter resistor R3a, R3b, R3i, R3k with a first filter resistor node and a second filter resistor node, and a filter capacitor C2a, C2b, C2i, C2k with a first filter capacitor node and a second filter capacitor node.

This may allow a simple and/or efficient way for designing the at least one time filter element. However, other ways to design the at least one time filter element are possible. In Fig. 4, filter resistor R3a and filter capacitor C2a are indicted as dashed elements. In some embodiments, in at least one time filter element no filter resistor and/or no filter capacitor may be present. This may allow a higher time resolution for this time filter element, for example time filter element 420a shown in Fig. 4.

As shown in Fig. 4, at least one time filter element 420a-420k may have the following properties: the first filter resistor node is coupled to the amplitude input 410a-410d and the second filter resistor node is coupled to the counter element 500 and wherein the first filter capacitor node is coupled to the filter resistor node and the second filter capacitor node is coupled to a ground potential. In Fig. 4, this is shown for all time filter elements 420a-420k. However, in some embodiments the topology of different time filter elements may be different, for example as explained with reference to time filter element 420a above.

The at least one duration detection element, for example at least one of the duration detection elements 400a-400d of Fig. 1 and/or the duration detection element of Fig. 4 may comprise: a third amplifier 403 coupled between the amplitude input 410a-410d and at least one of the duration detection elements 400a-400d.

The amplifier may decouple the amplitude signal from the duration detection element and thus improve the signal quality.

As shown in the embodiment of Fig. 4, the at least one time filter element 420a-420k may further comprise: a fourth amplifier 404a, 404b, 404i, 404k configured as a buffer and coupled between the amplitude input 410a-410d and the counter element 500, preferably, when dependent on claim 8, the fourth amplifier coupled between the second filter resistor node and the counter element 500.

The fourth amplifier may simplify the circuity required for the counter element 500.

As shown in Fig. 4, the counter element 500 may comprise: a plurality of registers N1-Nk for storing a histogram of noise and a reset input 510 for resetting the plurality of registers N1-Nk. Further, the counter element 500 may comprise a plurality of inputs q1-qk which may be connected to the respective fourth amplifiers.

Resetting the reset input may allow defining the time for which the information may be recorded, for example a noise histogram as detailed herein.

As shown for example in Fig. 1, Fig. 2, and Fig. 5, a control unit 600 may be present. While a control unit is not shown in Fig. 3, also in the embodiment of Fig. 3 a control unit may be present. The control unit may be an on-chip central processing unit, CPU.

The control unit 600 may be configured to trigger at least one measurement of the apparatus 100 to store at least one noise histogram 520, 530 in the counter element 500 for the at least one measurement. The control unit may be in addition or alternatively configured to determine at least one of safety status and a lifetime status, based on the at least one noise histogram.

The control unit may be in addition or alternatively configured to trim the input element 100 to a reference voltage level.

As shown in Fig. 1, control unit 600 may in addition or alternatively have other functions. For example, as indicated by the arrows in Fig. 1, control unit 600 may control settings of the plurality of amplitude detection elements 300, for example control amplitude thresholds, for example th_p1-th_pn and/or th_m1-thmn shown in Fig. 3.

As shown in Fig. 1, control unit 600 may control settings of at least one time filter element, for example by adjusting at least one time threshold. In some embodiments, control unit 600 may configure components of at least one duration detection element, for example a resistor value of a filter resistor and/or a capacitor value of a filter capacitor. To this end, filter resistor and/or capacitor resistor may be tunable components.

This may allow adopting the amplitude and/or time resolution of the apparatus 100.

Triggering at least one measurement may allow analyzing one or more analog signals at specific different times, for example during time intervals in which noisy events may occur, for example during startup, during operation, and/or during shutdown.

Fig. 5a shows a histogram according to an example embodiment. Fig. 5b shows a different histogram according to an example embodiment. The histograms 520 and 530 may be recorded by the apparatus 100 and/or by the method described herein. In Fig. 5a, in a table form for different filter times 524 the noise amplitude 522 is shown as a counter value. The counter value may be stored in the plurality of registers, for example in registers N1-Nk shown in Fig. 4. The filter times 524 shown in Fig. 5a may be the respective time thresholds associated with respective time filter elements as explained herein. The noise amplitudes 522 may correspond to the associated amplitude threshold levels described herein.

The histogram 530 shown in Fig. 5b may be recorded in a similar manner. In Fig. 5b the number of counter events 532 may be the content of the plurality of registers N1-Nk sorted by amplitude threshold level 534 which may correspond to the amplitude threshold levels th_p1, th_pn; th_m1, th_mn discussed herein.

Histograms 520, 530 may be recorded based on a triggering by the control unit at various times of operation. This may greatly enhance monitoring of a connected device.

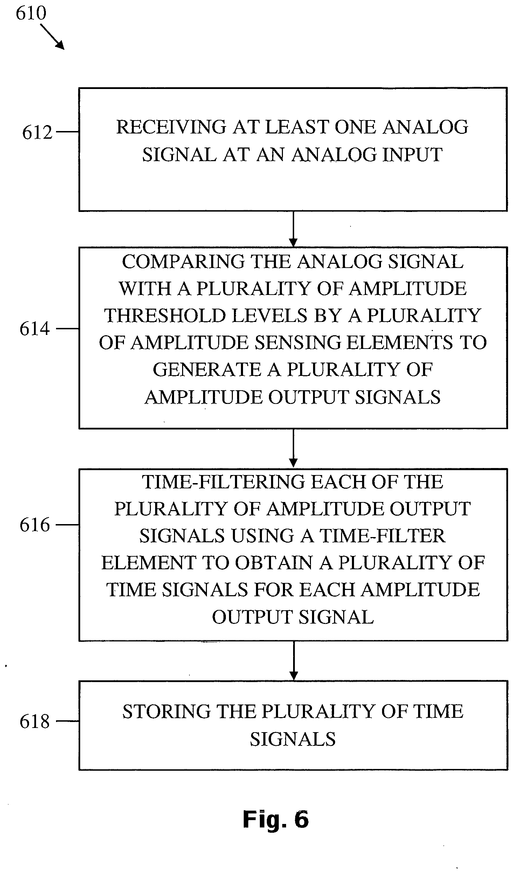

Fig. 6 shows a method 610 controlled by a control unit 600 according to an embodiment. As shown in Fig. 6, the method may comprise: At 612, receiving at least one analog signal at an analog input 210. At 614, comparing the analog signal with a plurality of amplitude threshold levels by a plurality of amplitude sensing elements to generate a plurality of amplitude output signals 320a, 320b; 320p1-320pn, 320m1-320mn. At 616, time-filtering each of the plurality of amplitude output signals using a time filter element 420a-420k to obtain a plurality of time signals q1, q2, qi, qn for each amplitude output signal. At 618, storing the plurality of time signals q1, q2, qi, qn.

This method may allow obtaining a histogram of the at least analog signal with the benefits described herein.

In one embodiment, the method comprises: determining, for a device, based on the plurality of time signals q1, q2, qi, qn at least one of the following: a noise histogram, a safety status, a lifetime status.

The noise histogram may be one of the noise histograms 520, 530 shown in Fig. 5a and Fig. 5b.

The method may further comprise: quantifying at least one of the following noise parameters for the at least one analog signal based on the plurality of time signals: amplitude, polarity, duration. This may simplify analysis of a monitored device.

The method may comprise: repeating the steps of receiving 612, comparing 614, time-filtering 616, and storing 618 at a plurality of times to obtain a temporal evolution of a noise histogram.

Analyzing the temporal evolution of a noise histogram may allow further details of the circuity and may allow for improved lifetime monitoring and trouble shooting.

The method may comprise: making a pass/fail decision based on the at least one noise histogram.

Using the noise histogram as disclosed herin to make a pass/fail decision may improve the accuracy of the pass/fail decision.

The method may be a built-in self-test, BIST.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
an input element comprising an analog signal node configured to receive at least one analog signal,
a plurality of amplitude sensing elements, each amplitude sensing element configured to:
receive the at least one analog signal from the analog signal node,
detect if the at least one analog signal at the analog signal node exceeds a respective amplitude threshold level associated with the amplitude sensing element, and
provide an amplitude signal at an amplitude output based on the detection;
a plurality of groups of duration detection elements,
each group of duration detection elements associated with one amplitude sensing element from the plurality of amplitude sensing elements, and
each duration detection element comprising a time filter element, wherein each duration detection element is configured to:
receive the amplitude signal from the amplitude output of the associated amplitude sensing element,
detect if a duration of the received amplitude signal exceeds a respective time threshold associated with the time filter element of the duration detection element, and
provide a duration signal based on the detection;
a counter element configured to store a count based on the respective duration signals of each duration detection element.

2. The apparatus of claim 1, the input element further comprising:
a plurality of analog input nodes, and
a selector, configured to select an input node from the plurality of input nodes and to connect the selected input node to the analog signal node.

3. The apparatus of any of the previous claims, wherein the received at least one analog signal is coupled to the analog signal node via a first capacitor.

4. The apparatus of any of the previous claims, wherein the input element further comprises a trimmable voltage divider, comprising: a first trimmable resistor, a second trimmable resistor, and a switch,
wherein the first trimmable resistor and the second trimmable resistor are coupled to the analog signal node and
wherein the first trimmable resistor is coupled to a voltage supply and the second trimmable resistor is coupled through the switch to a ground potential.

5. The apparatus of any of the previous claims, wherein at least one amplitude sensing element of the plurality of amplitude sensing elements further comprises:
a first amplifier with a first amplifier input and a first amplifier output,
the first amplifier input coupled to the input of the amplitude sensing element, wherein the first amplifier is an inverter, and
wherein the first amplifier is configured with the associated amplitude threshold level of the amplitude sensing element,
a second amplifier,
wherein the second amplifier is an inverter or a buffer, the second amplifier comprising a second amplifier input and a second amplifier output, the second amplifier input coupled to the first amplifier output and
the second amplifier output coupled to the amplitude output of the amplitude sensing element.

6. The apparatus of claim 5, wherein each of the second amplifiers has a common second threshold level.

7. The apparatus of any of the preceding claims, wherein the plurality of amplitude sensing elements comprises a first group and a second group, wherein in the first group all of the amplitude threshold levels are positive amplitude threshold levels above a reference level, and wherein in the second group all of the amplitude threshold levels are negative amplitude threshold values below the reference level.

8. The apparatus of any of the previous claims, wherein at least one time filter element of the duration detection element comprises:
a filter resistor with a first filter resistor node and a second filter resistor node, and
a filter capacitor with a first filter capacitor node and a second filter capacitor node.

9. The apparatus of claim 8, wherein in at least one time filter element:
the first filter resistor node is coupled to the amplitude input and
the second filter resistor node is coupled to the counter element and wherein
the first filter capacitor node is coupled to the filter resistor node and
the second filter capacitor node is coupled to a ground potential.

10. The apparatus of any of the previous claims, wherein at least one duration detection element comprises:
a third amplifier coupled between the amplitude input and at least one of the duration detection elements.

11. The apparatus of any of the previous claims, wherein at least one time filter element further comprises:
a fourth amplifier configured as a buffer and coupled between the amplitude input and the counter element, preferably, when dependent on claim 8, the fourth amplifier coupled between the second filter resistor node and the counter element.

12. The apparatus of any of the previous claims, wherein the counter element comprises:
a plurality of registers for storing a histogram of noise and
a reset input for resetting the plurality of registers.

13. The apparatus of any of the previous claims, wherein the apparatus further comprises: a control unit, the control unit configured to at least one of the following:
trigger at least one measurement of the apparatus to store at least one noise histogram in the counter element for the at least one measurement and further configured to
determine at least one of safety status and a lifetime status, based on the at least one noise histogram,
trim the input element to a reference voltage level.

14. A method controlled by a control unit, the method comprising:
receiving at least one analog signal at an analog input;
comparing the analog signal with a plurality of amplitude threshold levels by a plurality of amplitude sensing elements to generate a plurality of amplitude output signals;
time-filtering each of the plurality of amplitude output signals using a time filter element to obtain a plurality of time signals for each amplitude output signal;
storing the plurality of time signals.

15. The method of claim 14, further comprising: determining, for a device, based on the plurality of time signals at least one of the following:
a noise histogram,
a safety status,
a lifetime status.
